# DEMANDE DE BREVET EUROPEEN

(11) **EP 4 625 478 A1**
(43) Date de publication de la demande: **01.10.2025**
(21) Numéro de dépôt: 25165739.1
(22) Date de dépôt: 24.03.2025
(51) Int. Cl.: H01L 21/56, H01L 23/498

(54) **PROCÉDÉ DE D ASSEMBLAGE D'UN CIRCUIT INTÉGRÉ DANS LE SENS VERTICAL ET COMPOSANT INTÉGRANT UN CIRCUIT INTÉGRÉ VERTICAL**

(30) Priorité: 27.03.2024 FR 2403109
(71) Demandeur: Presto Engineering Group, 13590 Meyreuil (FR)
(72) Inventeur: BARIK, El Mostafa, 13100 AIX EN PROVENCE (FR); PATEL, Claire, 13120 GARDANNE (FR)
(74) Mandataire: Germain Maureau

(57) **Abrégé**

L'invention concerne un procédé de fabrication d'un composant (CMP) encapsulant un circuit intégré (CI), comprenant des étapes consistant à : fixer un circuit intégré sur un support (SB) et connecter des plages de connexion (CC) du circuit intégré à des plages de connexion (CP) du support ; former un premier ensemble de plots conducteurs (CP) alignés, s'étendant perpendiculairement au support, chacun des plots étant relié électriquement à une plage de connexion respective des plages de connexion du circuit intégré ; encapsuler le circuit intégré et les plots dans une couche de résine formée sur le support ; et découper le support et la couche de résine suivant un plan de découpe passant au travers de chacun des plots, de manière à former une face de découpe latérale dans laquelle chacun des plots présente une face exposée, les faces exposées des plots formant des plages de connexion latérales du composant.

## Description

### Domaine technique

La présente invention concerne le domaine de la mise en boitier des circuits intégrés.

### Etat de la technique

Les circuits intégrés sont généralement placés dans des boîtiers de protection pour faciliter leur manipulation et leur assemblage sur des cartes de circuit imprimé, tout en garantissant leur fonction avec une protection mécanique et environnementale. Un tel boîtier comprend généralement un support sur lequel est fixé le circuit intégré, et une couche de résine déposée sur le support et encapsulant le circuit intégré. Le support comprend des éléments de connexion du boitier, reliés à des plages de connexion du circuit intégré par des pistes conductrices ou des fils, le tout étant noyé dans une résine. Il existe un très grand nombre de types de boîtiers différents. Selon le type de boîtier, les éléments de connexion du boitier peuvent être répartis le long de bords du boîtier ou sur la surface inférieure de ce dernier, et peuvent se présenter sous la forme de pattes, de billes ou de plages de connexion à souder.

Certains circuits intégrés, notamment certains capteurs comme les capteurs magnétiques, les gyroscopes et les accéléromètres, présentent un unique axe de détection bien défini. Ces capteurs doivent pouvoir être fixés et connectés sur une carte de circuit imprimé par l'intermédiaire du boîtier, en autorisant une orientation de l'axe de détection du capteur dans l'une de trois directions non coplanaires ou perpendiculaires.

Il s'avère que le positionnement vertical d'un circuit intégré dans un boîtier soulève de nombreuses difficultés en termes de fabrication, de coût, de compacité, de performances et de dissipation thermique.

Il est donc souhaitable de développer un procédé de fabrication permettant d'assembler un circuit intégré en position verticale sur un substrat tel qu'une carte de circuit imprimé, qui ne présente pas ces inconvénients.

### Résumé

Des modes de réalisation concernent un procédé de fabrication d'un composant encapsulant un circuit intégré, comprenant des étapes consistant à : fixer un circuit intégré sur une première face d'un support et connecter des plages de connexion du circuit intégré à des plages de connexion du support ; former un premier ensemble de plots conducteurs alignés, s'étendant perpendiculairement au support depuis la première face du support ; former un second ensemble de plots conducteurs alignés dans un même plan avec les plots du premier ensemble de plots et s'étendant depuis une seconde face du support opposée à la première face, chacun des plots des premier et second ensembles de plots étant relié électriquement à l'une des plages de connexion du circuit intégré ; encapsuler le circuit intégré et les premier et second ensembles de plots dans des couches de résine formées sur les première et seconde face du support ; et découper le support et la couche de résine suivant un plan de découpe passant au travers de chacun des plots conducteurs des premier et second ensembles de plots, de manière à former une face de découpe latérale dans laquelle chacun des plots présente une face exposée, les faces exposées des plots conducteurs formant des plages de connexion latérales du composant pour fixer la face de découpe latérale du composant contre une plaque de circuit imprimé en connectant les plages de connexion latérales à des plages de connexion formées sur la plaque de circuit imprimé.

Grâce à ces dispositions, il est possible de fabriquer facilement un composant dans lequel est disposé un circuit intégré perpendiculairement à une face fixation et de connexion du composant. En effet, un tel composant peut ainsi être obtenu sans avoir à prévoir des étapes de fabrication supplémentaires. Par ailleurs, une telle position dite "verticale" est particulièrement utile notamment pour orienter un capteur ayant une direction de détection. Une telle position verticale est également particulièrement avantageuse en termes de surface occupée sur une plaque de circuit imprimé où est connecté le composant. Cette disposition du composant peut également être avantageuse en termes de dissipation thermique. En outre, le nombre de plages de connexion latérales du composant peut ainsi être multiplié par deux.

La formation de vias ne fait appel qu'à des techniques courantes et de tels vias sont présents dans de nombreux types de supports de circuits intégrés. Il en résulte que la formation de plages connexion latérales n'implique pas d'étapes de fabrication supplémentaires.

Selon un mode de réalisation, les plots des premier et second ensembles de plots s'étendent au travers de la couche de résine jusqu'à des plages de connexion formées sur le support.

Ainsi, la surface de chacune des plages de connexion latérales dépend de la hauteur et de la largeur ou diamètre des plots. Cette surface peut donc être adaptée en fonction des besoins, sachant que l'épaisseur de la couche de résine et donc du composant dépend de la hauteur des plots et que le nombre maximum de plages de connexion latérales ou de plots dépend de la largeur de ces derniers.

Selon un mode de réalisation, les plots des premier et second ensembles de plots sont formés en réalisant des trous au travers de la couche de résine jusqu'au support, et en remplissant les trous d'un matériau conducteur.

Ainsi, la couche de résine peut être utilisée comme moule pour former les plots.

Selon un mode de réalisation, le procédé comprend une étape de finition comportant des opérations de polissage de la face de découpe.et de dépôt d'une couche protectrice conductrice sur les plages de connexion latérales.

Il est ainsi possible d'obtenir des plages de connexion latérales ayant les qualités requises, aussi bonnes que des plages de connexion formées sur la face supérieure ou inférieure d'un composant classique.

Selon un mode de réalisation, les plages de connexion du circuit intégré sont reliées par des fils aux plages de connexion du support, les fils étant noyés dans la couche de résine, ou bien les plages de connexion du circuit intégré sont soudées aux plages de connexion du support.

Le procédé selon l'invention s'applique aussi bien aux techniques de connexion des circuits intégrés par des fils ou par des plages de connexion et des pistes conductrices formées dans le support.

Selon un mode de réalisation, une pluralité de circuits intégrés sont fixés en lignes et en colonnes sur le support, les plages de connexion de chacun des circuits intégrés étant connectées à des plages de connexion respectives du support, l'étape de découpe du support séparant les circuits intégrés les uns des autres et formant des composants séparés.

Des modes de réalisation peuvent également concerner un composant électronique comprenant : un circuit intégré, et un support, le composant étant obtenu par le procédé défini précédemment.

Selon un mode de réalisation, le support est formé dans une plaque comportant plusieurs couches comprenant au moins deux couches dans lesquelles sont formées des pistes conductrices et une couche en un diélectrique.

### Brève description des figures

La présente invention sera bien comprise à l'aide de la description qui suit d'exemples de réalisation en référence aux figures annexées, dans lesquelles des signes de références identiques correspondent à des éléments structurellement et/ou fonctionnellement identiques ou similaires.
Les figures 1A et 1B sont des vues schématiques de dessus et de face d'un circuit intégré fixé sur un support, à une première étape de fabrication d'un composant encapsulant le circuit intégré, selon un premier mode de réalisation,
Les figures 2A et 2B sont des vues schématiques de dessus et de face du circuit intégré fixé sur le support, à une seconde étape de fabrication du composant encapsulant le circuit intégré, selon le premier mode de réalisation,
Les figures 3A et 3B sont des vues schématiques de dessus et de face du circuit intégré fixé sur le support, à une troisième étape de fabrication du composant encapsulant le circuit intégré, selon le premier mode de réalisation,
Les figures 4A et 4B sont des vues schématiques de face et latérale, respectivement, du composant de la figure 3A monté sur une plaque de circuit imprimé, selon un mode de réalisation,
Les figures 5A et 5B sont des vues schématiques de face et latérale d'un circuit intégré fixé sur un support, à une première étape de fabrication d'un composant encapsulant le circuit intégré, selon un deuxième mode de réalisation,
Les figures 6A et 6B sont des vues schématiques de face et latérale du circuit intégré fixé sur le support, à une seconde étape de fabrication du composant encapsulant le circuit intégré, selon le deuxième mode de réalisation,
Les figures 7A et 7B sont des vues schématiques de face et latérale du circuit intégré fixé sur le support, à une troisième étape de fabrication du composant encapsulant le circuit intégré, selon le deuxième mode de réalisation,
Les figures 8A et 8B sont des vues schématiques de face et latérale du circuit intégré fixé sur le support, à une quatrième étape de fabrication du composant encapsulant le circuit intégré, selon le deuxième mode de réalisation,
Les figures 9A et 9B sont des vues schématiques latérale et de face respectivement, du composant de la figure 8A monté sur une plaque de circuit imprimé, selon un mode de réalisation,
Les figures 10A et 10B sont des vues schématiques de face et latérale du circuit intégré fixé sur le support, à la troisième étape de fabrication du composant encapsulant le circuit intégré, selon un troisième mode de réalisation,
Les figures 11A et 11B sont des vues schématiques de face et latérale du circuit intégré fixé sur le support, à une quatrième étape de fabrication du composant encapsulant le circuit intégré, selon le troisième mode de réalisation,
La figure 12 est une vue schématique de dessus d'une plaque de circuit imprimé à découper supportant une pluralité d'exemplaires du circuit intégré, selon un mode de réalisation,
La figure 13 est une vue schématique de dessus d'une plaque de circuit imprimé à découper supportant une pluralité d'exemplaires du circuit intégré, selon un autre mode de réalisation,
Les figures 14A et 14B sont des vues schématiques de face et latérale d'un circuit intégré fixé sur un support, à une première étape de fabrication d'un composant encapsulant le circuit intégré, selon un quatrième mode de réalisation,
Les figures 15A et 15B sont des vues schématiques de face et latérale du circuit intégré fixé sur le support, à une seconde étape de fabrication du composant encapsulant le circuit intégré, selon le quatrième mode de réalisation,
Les figures 16A et 16B sont des vues schématiques de face et latérale du circuit intégré fixé sur le support, à une troisième étape de fabrication du composant encapsulant le circuit intégré, selon le quatrième mode de réalisation,
Fig 17] Les figures 17A et 17B sont des vues schématiques de face et latérale du circuit intégré fixé sur le support, à une quatrième étape de fabrication du composant encapsulant le circuit intégré, selon le quatrième mode de réalisation,
Les figures 18A et 18B sont des vues schématiques de face et latérale du circuit intégré fixé sur un support, à une première étape de fabrication d'un composant encapsulant le circuit intégré, selon un cinquième mode de réalisation,
Les figures 19A et 19B sont des vues schématiques de face et latérale du circuit intégré fixé sur le support, à une seconde étape de fabrication du composant encapsulant le circuit intégré, selon le cinquième mode de réalisation,
Les figures 20A et 20B sont des vues schématiques de face et latérale du circuit intégré fixé sur le support, à une troisième étape de fabrication du composant encapsulant le circuit intégré, selon le cinquième mode de réalisation,
Les figures 21A et 21B sont des vues schématiques de face et latérale du circuit intégré fixé sur le support, à une quatrième étape de fabrication du composant encapsulant le circuit intégré, selon le cinquième mode de réalisation.

### Description détaillée

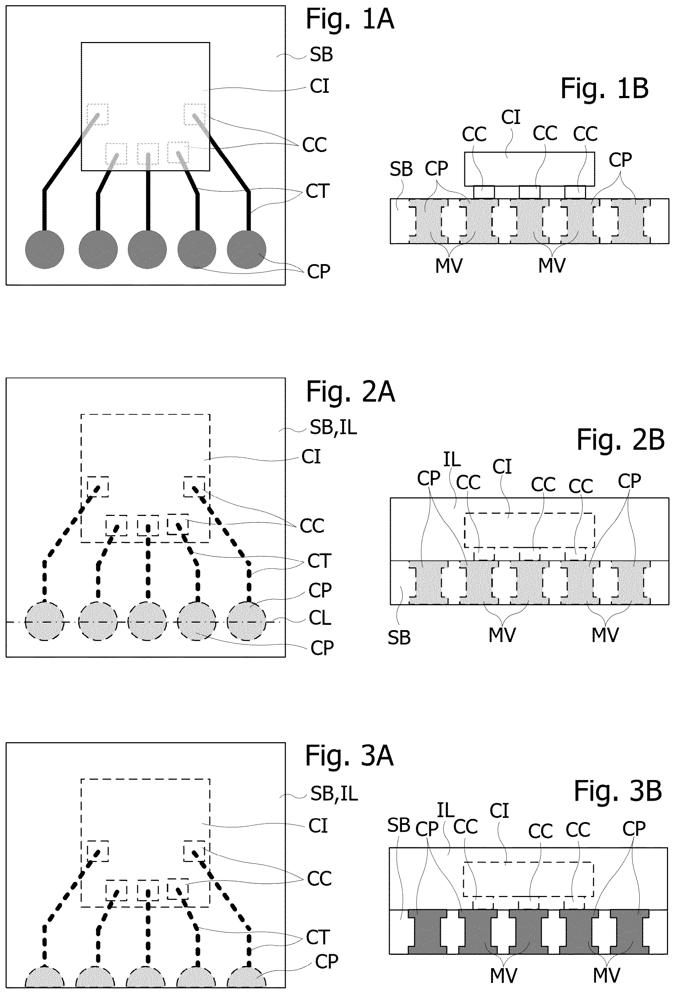

Les figures 1A et 1B représentent un circuit intégré CI et un support SB, à une première étape de fabrication d'un composant dans lequel le circuit intégré est encapsulé, selon un premier mode de réalisation. Le support SB est un substrat laminé pouvant comporter une ou plusieurs couches de pistes conductrices séparées par des couches diélectriques, par exemple de type organique. Les différentes couches de pistes conductrices sont reliées entre elles par des éléments conducteurs verticaux appelés "vias". Le circuit intégré CI lui-même peut comprendre par exemple un substrat semi-conducteur, plusieurs couches de pistes conductrices séparées par des couches diélectriques et des plages de connexion CC formées sur une face supérieure. Le circuit intégré CI peut également être déjà encapsulé dans un boitier par exemple de type WLP ("Wafer-level packaging") et muni de plages de connexion, par exemple de type LGA ("Land Grid Array") ou BGA ("Ball Grid Array").

Lors de la première étape de fabrication, le circuit intégré CI est assemblé en étant retourné selon la technique "flip chip" de manière à placer les plages de connexion CC en regard de plages de connexion CP formées sur le support SB. Les plages de connexion CC sont ensuite soudées sur les plages de connexion CP, par exemple à l'aide de pâte à braser. Chacune des plages de connexion CP du support est reliée par une piste conductrice CT à un trou métallisé ou via MV respectif, formé dans le support SB. Les vias MV sont alignés.

Le circuit CI peut également être disposé sur le support SB sans être retourné, c'est-à-dire, avec la face du circuit comportant les plages de connexion CC tournée vers le haut, les plages de connexion CC étant reliées aux plages de connexion CP du support SB par des fils (par la technique "wire bonding").

Les figures 2A et 2B représentent le circuit intégré CI fixé sur le support SB, à une deuxième étape de fabrication du composant. Lors de la deuxième étape, la face supérieure du support SB est entièrement recouverte d'une couche de résine IL encapsulant le circuit intégré CI et recouvrant toute la face supérieure du support SB.

Les figures 3A et 3B représentent le circuit intégré CI fixé sur le support SB, à une troisième étape de fabrication du composant. Lors de la troisième étape, le support SB et la couche de résine IL sont découpés suivant un plan de découpe CL perpendiculaire à la face supérieure du support (figure 2A). Le plan de découpe CL passe par tous les vias MV (par exemple par le centre de chacun des vias. Ainsi, à la suite de l'opération de découpe, chacun des vias MV présente une face exposée formant une plage de connexion latérale du composant. L'opération de découpe peut être suivie d'une étape de finition comprenant des opérations de polissage des faces exposées des vias, et de dépôt sur cette face d'une couche protectrice (anticorrosion, anti-oxydation), par exemple par un procédé ENEPIG ("Electroless Nickel Electroless Palladium Immersion Gold").

Les étapes précédemment décrites jusqu'à l'encapsulation dans la résine, peuvent être réalisées collectivement pour un grand nombre de circuits intégrés disposés sur le support SB, les composants ainsi réalisés étant ensuite individualisés, par des opérations de découpe notamment suivant la ligne de découpe SL.

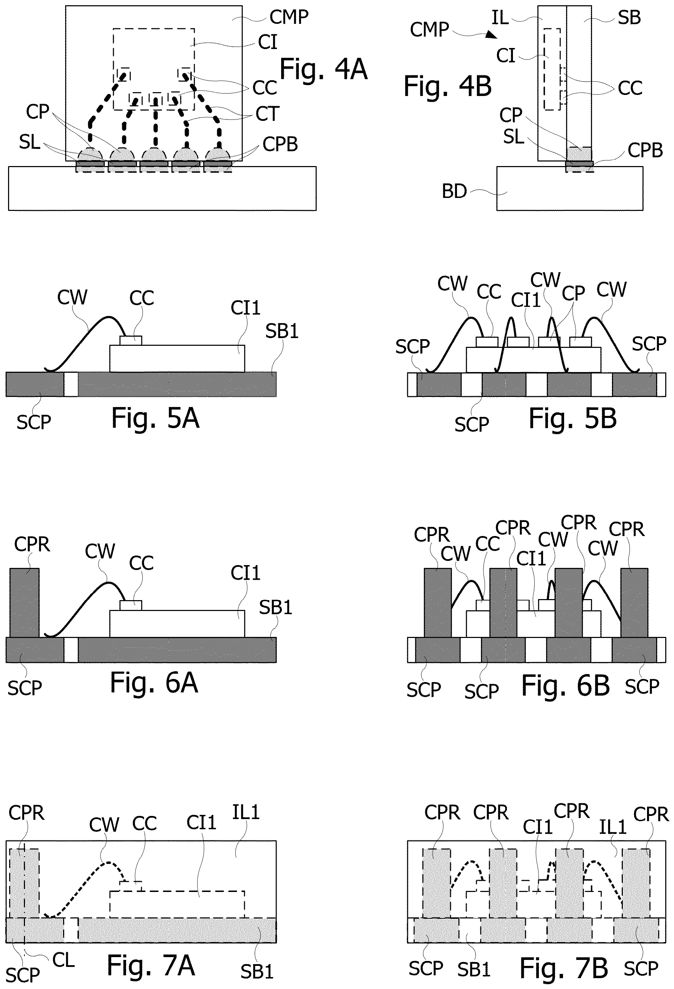

La figure 4 représente le composant CMP de la figure 3A monté sur une plaque de circuit imprimé BD, selon un mode de réalisation. La plaque de circuit imprimé BD comprend des plages de connexion CPB auxquelles sont soudés, par exemple à l'aide d'une pâte à braser SL, les vias MV coupés, polis et protégés par une finition (couche de protection conductrice ?) formant des plages de connexion latérales du composant CMP.

Les figures 5A et 5B représentent un circuit intégré CI1 fixé sur un support SB1, à une première étape de fabrication d'un composant encapsulant le circuit intégré, selon un deuxième mode de réalisation. Le support SB1 de type "leadframe", se présente sous la forme d'une plaque métallique (par exemple en alliage de cuivre), avec des évidements délimitant un élément support du circuit intégré CI1, des pistes conductrices et des plages de connexion SCP, formés par gravure chimique ou estampage. Ainsi, une plaque Leadframe peut former une matrice de plusieurs lignes et colonnes de supports de circuits intégrés pour former après moulage et découpe plusieurs dizaines voire plusieurs centaines de botiers. À l'étape de fabrication illustrée par les figures 5A, 5B, le circuit intégré CI1 est disposé sur le support SB1, la face supportant les plages de connexion CC du circuit intégré étant tournée vers le haut. Les plages de connexion CC du circuit sont reliées chacune à une plage de connexion SCP du support SB1, par un fil conducteur CW soudé à chaque extrémité.

Les figures 6A et 6B représentent le circuit intégré CI1 fixé sur le support SB1, à une seconde étape de fabrication du composant, selon le deuxième mode de réalisation. À cette étape, des plots conducteurs CPR, par exemple en cuivre sont formés sur les plages de connexion SCP. Les plots conducteurs CPR peuvent être déposés sur le support SB1 avant l'assemblage du circuit intégré CI1. Les plots conducteurs CPR peuvent présenter une hauteur supérieure à celle du circuit intégré CI1 au-dessus du support SB1.

Les plots conducteurs peuvent par exemple être réalisés en déposant sur le support SB1 une couche conductrice d'accroche par exemple par pulvérisation ("sputtering"), puis une couche de résine photosensible qui est exposée à une lumière ultraviolette, puis développée de manière à former des trous aux emplacements des plots à réaliser. Les trous peuvent ensuite être remplis de cuivre par exemple par dépôt électrochimique. Finalement, les couches de résine photosensible et d'accroche sont complètement retirées, laissant des plots en cuivre. Ces opérations peuvent être répétées plusieurs fois pour augmenter la hauteur des plots, si nécessaire.

Les figures 7A et 7B représentent le circuit intégré CI1 fixé sur le support SB1, à une troisième étape de fabrication du composant encapsulant le circuit intégré, selon le deuxième mode de réalisation. À cette étape, le circuit intégré CI1, les fils conducteurs CW, et les plots CPR sont noyés dans une couche de résine IL1 déposée sur le support SB1 et les éléments support SBC. La couche de résine IL1 présente une épaisseur supérieure à la hauteur des plots CPR sur le support SB1.

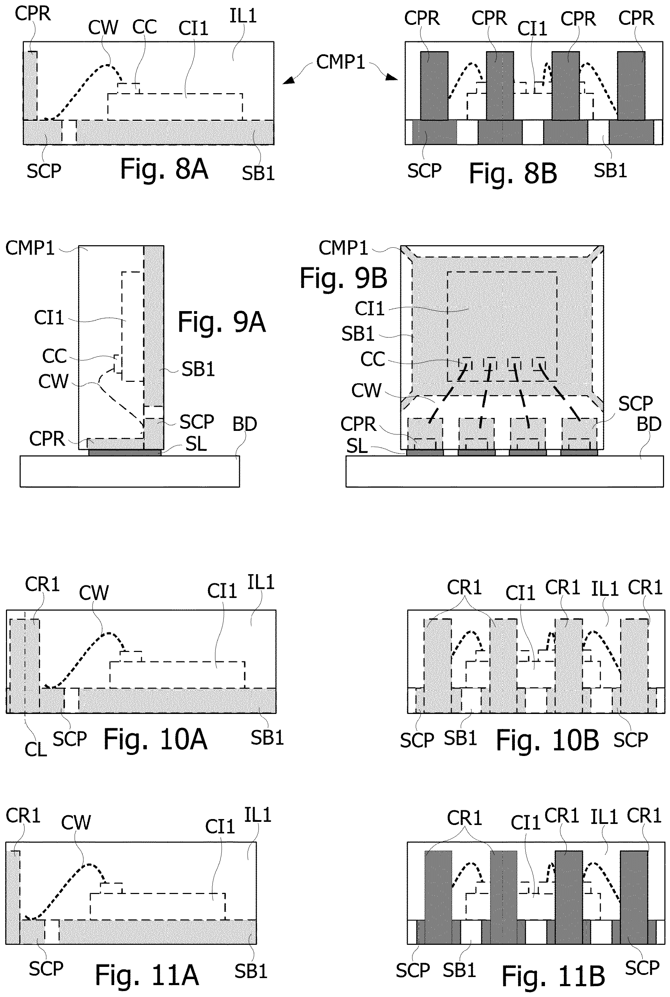

Les figures 8A et 8B représentent le circuit intégré CI1 fixé sur le support SB1, à une quatrième étape de fabrication du composant encapsulant le circuit intégré, selon le deuxième mode de réalisation. Lors de la quatrième étape, le support SB1 et la couche de résine IL1 sont découpés suivant un plan de découpe CL par exemple perpendiculaire à la face supérieure du support (figure 7A). Le plan de découpe CL passe par tous les plots CPR, par exemple par le centre de chacun des plots. Ainsi, chacun des plots CPR présente une face latérale exposée formant une plage de connexion latérale du composant.

La figure 9 représente le composant CMP1 de la figure 8A monté sur une plaque de circuit imprimé BD, selon un mode de réalisation. La plaque de circuit imprimé BD comprend des plages de connexion CPB auxquelles sont soudés, à l'aide d'un matériau de soudage SL, les plots CPR coupés, formant des plages de connexion latérales du composant CMP1.

Les figures 10A, 10B, 11A, et 11B illustrent des étapes alternatives au deuxième mode de réalisation.

Les figures 10A et 10B représentent le circuit intégré CI1 fixé sur le support SB1, à une troisième étape de fabrication du composant encapsulant le circuit intégré, selon le troisième mode de réalisation. Lors de cette étape, le circuit intégré CI1, les fils conducteurs CW, et les plages de connexion CP sont noyés dans la couche de résine IL1 déposée sur le support SB1 et les plages de connexion SCP. Ensuite, des trous sont formés au travers des couches de résine IL1, et des plages de connexion SCP. Les trous ainsi réalisés sont ensuite remplis d'un matériau conducteur pour former des plots CR1. Ces trous forment ainsi des moules pour réaliser les plots. Les plots CR1 peuvent ainsi être formés aux mêmes emplacements que les plots CPR.

A une étape suivante illustrée par les figures 11A et 11B, les éléments support SBC, la couche de résine IL1 et les plots CR1 sont découpés comme précédemment, suivant le plan de découpe CL (figure 11A) qui passe par tous les plots CR1, par exemple par le centre de chacun des plots.

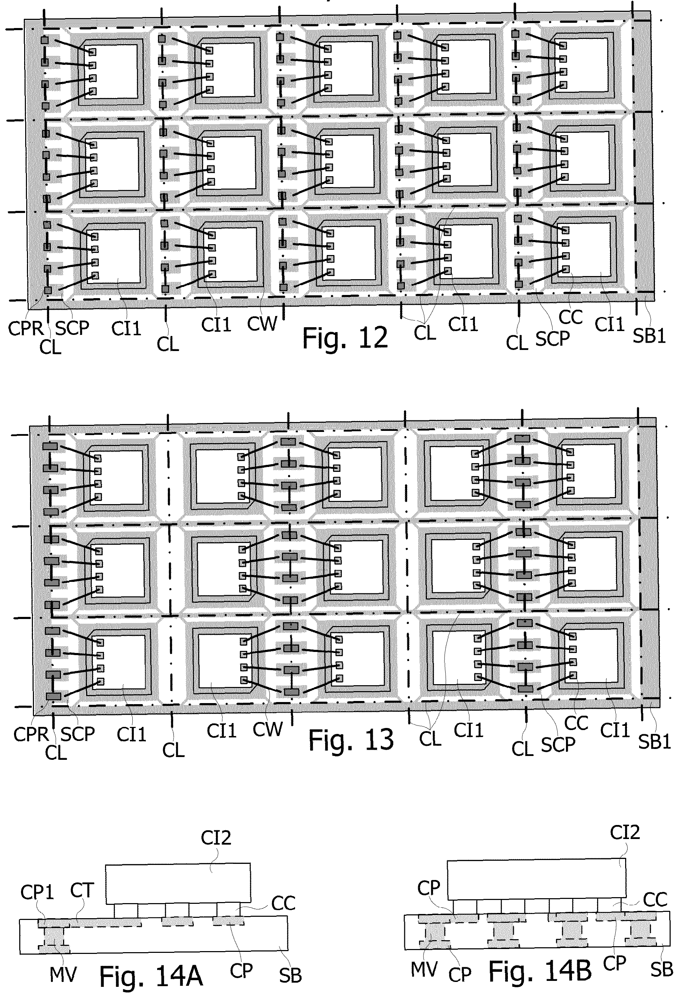

Les figures 12 et 13 illustrent des procédés de fabrication collective de composants intégrant un circuit intégré tel que CI1. Les figures 12 et 13 représentent une plaque métallique formant le support SB1 sur laquelle sont disposés des circuits intégrés CI1 alignés en lignes et en colonnes, en vue d'une fabrication collective des composants CMP1. Les plages de connexion SCP formées sur la plaque SB1 et les plots CPR (ou CR1) formés sur les plages de connexion CP sont alignés en colonnes entre deux paires de colonnes de circuits intégrés CI1. Des plots CPR (ou CR1) sont formés sur les plages de connexion SCP. L'ensemble est recouvert de la couche de résine IL1. Les figures 12 et 13 montrent également les plans de découpe CL de la plaque SB1 pour séparer les composants encapsulant chacun l'un des circuits intégrés CI1. Les plans de découpe CL s'étendent entre chaque ligne et chaque colonne de circuits intégrés CI1. Les plans de découpe CL entre les colonnes de circuits intégrés CI1 passent par les plages de connexion SCP et des plots CPR (ou CR1).

Dans l'exemple de la figure 12, chacune des plages de connexion SCP formées sur la plaque SB1, est connectée à une plage de connexion CC d'un circuit intégré CI1.

Dans l'exemple de la figure 13, une colonne de circuits intégrés CI1 est pivotée de 180°, et chaque colonne de circuits intégrés CI1 partage ainsi avec une autre colonne adjacente de circuits intégrés CI1 une colonne de plages de connexion SCP et de plots CPR. Une ligne de découpe CL sur deux, passant entre les colonnes de circuits intégrés CI1 sépare en deux une colonne de plages de connexion SCP et de plots CPR. Ainsi, chaque plot CPR est découpé pour former une plage de connexion latérale de deux composants adjacents sur la figure 13.

Les figures 14A et 14B représentent un circuit intégré CI2 fixé sur un support SB, à une première étape de fabrication d'un composant encapsulant le circuit intégré, selon un quatrième mode de réalisation. Le support SB est un substrat laminé pouvant comporter un ou plusieurs plans de pistes conductrices, séparés par des couches diélectriques. Le circuit intégré CI2 est assemblé en position retournée selon la technique "flip chip" de manière à placer les plages de connexion CC du circuit CI2 en regard du support SB sur des plages de connexion CP formées sur le support SB sur lesquelles elles sont soudées. Chacune des plages de connexion CP du support est reliée par une piste conductrice CT à un trou métallisé ou via MV formé dans le support SB. Les vias MV sont sensiblement alignés, de manière à pouvoir être coupés simultanément par un plan de découpe orienté suivant leurs axes longitudinaux respectifs.

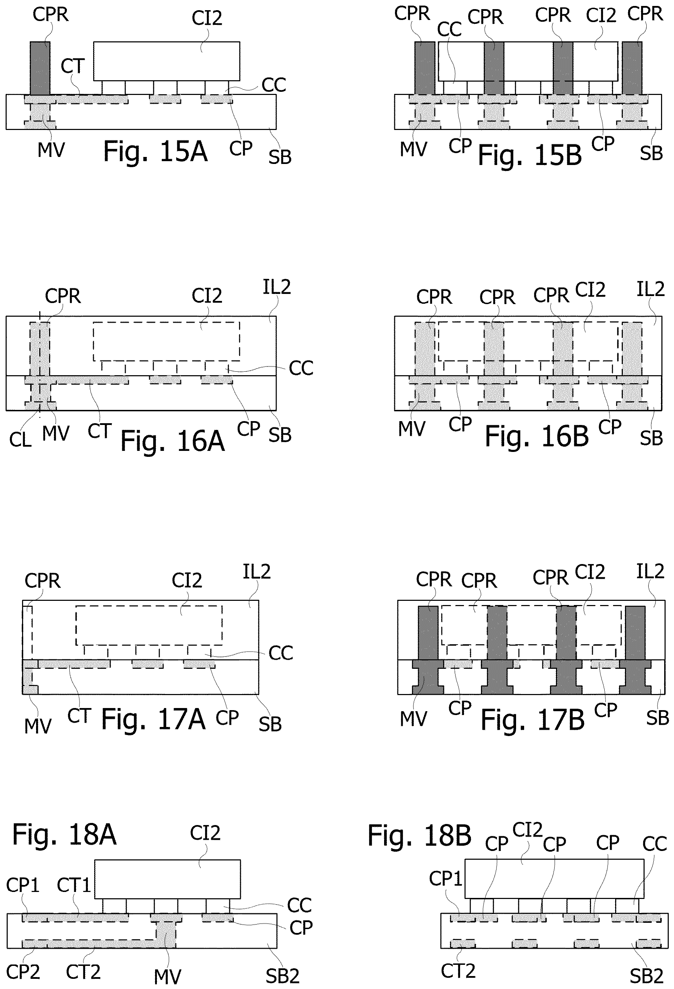

Les figures 15A et 15B représentent le circuit intégré CI1 fixé sur le support SB, à une seconde étape de fabrication du composant encapsulant le circuit intégré, selon le quatrième mode de réalisation. Lors de cette étape, des plots conducteurs CPR, par exemple en cuivre, sont formés sur les vias MV.

Les figures 16A et 16B représentent le circuit intégré CI2 fixé sur le support SB, à une troisième étape de fabrication du composant encapsulant le circuit intégré, selon le quatrième mode de réalisation. Lors de cette étape, la face supérieure du support SB est entièrement recouverte d'une couche de résine IL2 encapsulant le circuit intégré CI et les plots CPR.

Les figures 17A et 17B représentent le circuit intégré CI2 fixé sur le support SB, à une quatrième étape de fabrication du composant encapsulant le circuit intégré, selon le quatrième mode de réalisation. Lors de cette étape, le support SB, la couche de résine IL2 et les plots CPR sont découpés suivant un plan de découpe CL par exemple perpendiculaire à la face supérieure du support (figure 16A). Le plan de découpe CL passe par tous les vias MV et les plots CPR, par exemple par le centre de chacun des via et des plots. Ainsi, à la suite de l'opération de découpe, chacun des vias MV et des plots CPR présente une face exposée formant une plage de connexion latérale du composant. De cette manière la surface exposée de chacun des vias est étendue à la surface exposée d'un des plots CPR pour former une plage de connexion du composant. Par rapport au premier mode de réalisation (figures 1 à 3), les plages de connexion ainsi réalisées présentent une plus grande surface, permettant de réaliser des connexions de meilleure qualité du composant ainsi obtenu. Cependant, la formation des vias MV peut être omise, sachant que la surface de découpe latérale de chacun des plots CPR peut être plus grande que la surface latérale de découpe de chacun des vias MV du premier mode de réalisation.

Selon un mode de réalisation alternatif, les plots CPR sont formés après le dépôt de la couche de résine IL2 en réalisant des trous dans la couche de résine IL2, jusqu'aux vias MV ou traversant l'épaisseur du support SB au travers des vias MV. Les trous sont ensuite remplis d'un matériau conducteur, formant ainsi les plots CPR.

Le procédé selon le quatrième mode de réalisation (figures 14 à 17) peut utiliser le même circuit intégré et le même support que dans le premier mode de réalisation.

Les figures 18A et 18B représentent le circuit intégré CI2 fixé sur le support SB2, à une première étape de fabrication d'un composant encapsulant le circuit intégré, selon un cinquième mode de réalisation. Le circuit intégré CI2 est assemblé en position retournée selon la technique "flip chip" de manière à placer les plages de connexion CC du circuit CI2 en regard de la face supérieure du support SB2 sur des plages de connexion CP formées sur le support SB2 sur lesquelles elles sont soudées. Certaines des plages de connexion CP du support SB2 sont reliées à des plages de connexion CP1 par des pistes conductrices CT1 respectives. Les autres plages de connexion CP sont reliées par un trou métallisé ou via MV formé dans le support SB2 à une piste conductrice CT2 respective formée sur une face inférieure du support. Les plages de connexion CP1, CP2 sont sensiblement alignées, de manière à pouvoir être coupées simultanément par un plan de découpe orienté suivant leurs axes longitudinaux respectifs.

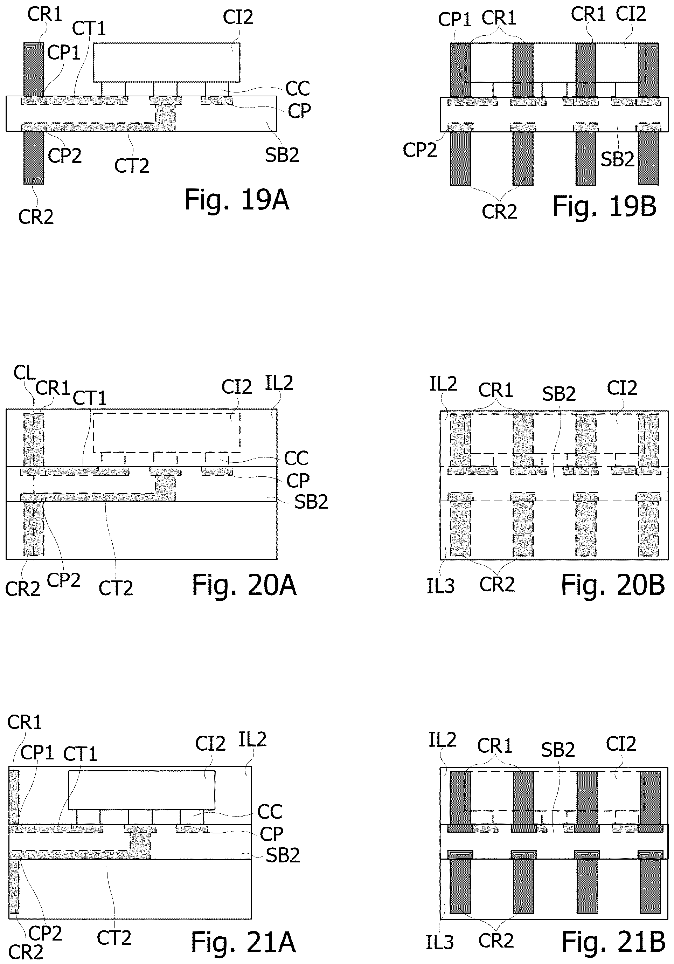

Les figures 19A et 19B représentent le circuit intégré CI2 fixé sur le support SB2, à une seconde étape de fabrication du composant encapsulant le circuit intégré, selon le cinquième mode de réalisation. Lors de cette étape, des plots conducteurs CPR1, CPR2, par exemple en cuivre, sont formés sur chacune des faces supérieure et inférieure du support SB2 sur les plages de connexion CP1, CP2.

Les figures 20A et 20B représentent le circuit intégré CI2 fixé sur le support SB2, à une troisième étape de fabrication du composant encapsulant le circuit intégré, selon le cinquième mode de réalisation. Lors de cette étape, les faces supérieure et inférieure du support SB2 sont entièrement recouvertes de couches de résine IL2, IL2 encapsulant le circuit intégré CI et les plots CR1, CR2.

Les figures 21A et 21B représentent le circuit intégré CI2 fixé sur le support SB2, à une quatrième étape de fabrication du composant encapsulant le circuit intégré, selon le cinquième mode de réalisation. Lors de cette étape, le support SB2, la couche de résine IL2 et les plots CR1, CR2 sont découpés suivant un plan de découpe CL par exemple perpendiculaire à la face supérieure du support (figure 20A). Le plan de découpe CL passe par tous les plots CR1, C2, par exemple par le centre de chacun des via et des plots. Ainsi, à la suite de l'opération de découpe, chacun des plots CR1, C2 présente une face exposée formant une plage de connexion latérale du composant. De cette manière, le nombre de plages de connexion latérales du composant peut être multiplié par deux.

Selon un mode de réalisation alternatif, les plots CR1, CR2 sont formés après le dépôt des couches de résine IL2, IL3 en réalisant des trous dans les couches de résine IL2, IL3, jusqu'aux plages de connexion CP1, CP2. Les trous sont ensuite remplis d'un matériau conducteur, formant ainsi les plots CR1, CR2.

Le procédé selon le cinquième mode de réalisation (figures 18 à 21) peut utiliser le même circuit intégré et le même support que dans le premier mode de réalisation.

Il est à noter que dans les deuxièmes à quatrième modes de réalisation (figures 5 à 17), les plots peuvent être formés uniquement sur la face du support opposée à celle où est disposé le circuit intégré.

Il apparaîtra clairement à l'homme de l'art que la présente invention est susceptible de diverses variantes de réalisation et diverses applications. En particulier, l'invention n'est pas limitée au mode de réalisation des plots précédemment décrit, sachant qu'il existe plusieurs façons de réaliser des plots sur un substrat. Il convient également de noter que les plots ne sont pas nécessairement formés au-dessus de vias, mais simplement sur une pastille conductrice formée sur le support.

Par ailleurs, l'étape de finition appliquée aux plages de connexion latérales peut être omise dans certaines applications, et selon la technique de découpe du support mise en œuvre.

## Revendications

1. Procédé de fabrication d'un composant (CMP, CMP1) encapsulant un circuit intégré (CI, CI1, CI2), comprenant des étapes consistant à :
fixer un circuit intégré sur une première face d'un support (SB, SB1, SB2) et connecter des plages de connexion (CC) du circuit intégré à des plages de connexion (CP, SCP) du support ;
former un premier ensemble de plots conducteurs (MV, CPR, CR1, CR2) alignés, s'étendant perpendiculairement au support depuis la première face du support ;
former un second ensemble de plots conducteurs (CR2) alignés dans un même plan avec les plots du premier ensemble de plots et s'étendant depuis une seconde face du support opposée à la première face, chacun des plots des premier et second ensembles de plots étant relié électriquement à l'une des plages de connexion (CC) du circuit intégré (CI2) ;
encapsuler le circuit intégré et les premier et second ensembles de plots dans des couches de résine (IL, IL1, IL2, IL3) formées sur les première et seconde face du support ; et
découper le support et la couche de résine suivant un plan de découpe (CL) passant au travers de chacun des plots conducteurs des premier et second ensembles de plots, de manière à former une face de découpe latérale dans laquelle chacun des plots conducteurs présente une face exposée, les faces exposées des plots formant des plages de connexion latérales du composant pour fixer la face de découpe latérale du composant contre une plaque de circuit imprimé (BD) en connectant les plages de connexion latérales à des plages de connexion (CPB) formées sur la plaque de circuit imprimé.

2. Procédé selon la revendication 1, dans lequel les plots des premier et second ensembles de plots (CPR, CR1, CR2) s'étendent au travers de la couche de résine (IL1, IL2, IL3) jusqu'à des plages de connexion (SCP, CP1, CP2) formées sur le support (SB, SB1, SB2).

3. Procédé selon la revendication 1 ou 2, dans lequel les plots des premier et/ou second ensembles de plots (CR1, CR2) sont formés en réalisant des trous au travers de la couche de résine (IL1, IL2, IL3) jusqu'au support (SB2), et en remplissant les trous d'un matériau conducteur.

4. Procédé selon l'une des revendications 1 à 3, comprenant une étape de finition comportant des opérations de polissage de la face de découpe et de dépôt d'une couche protectrice conductrice sur les plages de connexion latérales.

5. Procédé selon l'une des revendications 1 à 4, dans lequel les plages de connexion (CC) du circuit intégré (CI, CI1) sont reliées par des fils (CW) aux plages de connexion du support (SB, SB1), les fils étant noyés dans la couche de résine (IL1), ou bien les plages de connexion (CC) du circuit intégré (CI, CI2) sont soudées aux plages de connexion (CP) du support (SB, SB2).

6. Procédé selon l'une des revendications 1 à 5, dans lequel une pluralité de circuits intégrés (CI, CI1, CI2) sont fixés en lignes et en colonnes sur le support (SB, SB1, SB2), les plages de connexion (CC) de chacun des circuits intégrés étant connectées à des plages de connexion (CP, SCP) respectives du support, l'étape de découpe du support séparant les circuits intégrés les uns des autres et formant des composants séparés.

7. Composant électronique comprenant :
un circuit intégré (CI, CI1, CI2), et
un support (SB, SB1, SB2), le composant étant obtenu par le procédé selon l'une des revendications 1 à 6.

8. Composant électronique selon la revendication 7, dans lequel le support est formé dans une plaque (SB, SB2) comportant plusieurs couches comprenant au moins deux couches dans laquelle sont formées des pistes conductrices (CT) et une couche en un diélectrique.
